# FASCICULE DE BREVET EUROPEEN

(11) **EP 3 602 644 B1**
(45) Date de publication et mention de la délivrance du brevet: **21.02.2024**
(21) Numéro de dépôt: 18722093.4
(22) Date de dépôt: 27.03.2018
(51) Int. Cl.: H10N 30/079, H10N 30/00, H01L 21/20, H01L 21/762, H10N 30/073, H03H 3/08, H03H 9/02

(54) **PROCÉDÉ D'AJUSTEMENT DE L'ÉTAT DE CONTRAINTE D'UN FILM PIÉZOÉLECTRIQUE ET DISPOSITIF À ONDE ACOUSTIQUE EMPLOYANT UN TEL FILM**
VERFAHREN ZUR ANPASSUNG DES SPANNUNGSZUSTANDS EINES PIEZOELEKTRISCHEN FILMS UND AKUSTIKWELLENVORRICHTUNG MIT VERWENDUNG SOLCH EINES FILMS
METHOD FOR ADJUSTING THE STRESS STATE OF A PIEZOELECTRIC FILM AND ACOUSTIC WAVE DEVICE EMPLOYING SUCH A FILM

(30) Priorité: 31.03.2017 FR 1752733
(43) Date de publication de la demande: 05.02.2020
(73) Titulaire: Soitec, 38190 Bernin (FR)
(72) Inventeur: BETHOUX, Jean-Marc, 38500 La Buisse (FR); SINQUIN, Yann, 38000 Grenoble (FR); RADISSON, Damien, 38190 Brignoud (FR)
(74) Mandataire: IP Trust
(86) Numéro de dépôt international: PCT/FR2018/050744
(87) Numéro de publication internationale: WO 2018/178562

(56) Documents cités:
- EP-A1- 2 159 836
- JP-A- 2000 244 030
- JP-A- 2009 201 101
- US-A1- 2003 117 041
- US-A1- 2015 115 480
- HOBART K D ET AL: "COMPLIANT SUBSTRATES: A COMPARATIVE STUDY OF THE RELAXATION MECHANISMS OF STRAINED FILMS BONDED TO HIGH AND LOW VISCOSITY OXIDES", JOURNAL OF ELECTRONIC MATERI, WARRENDALE, PA, US, vol. 29, no. 7, 1 janvier 2000 (2000-01-01), pages 897-900, XP009020920, ISSN: 0361-5235

## Description

### DOMAINE DE L'INVENTION

La présente invention porte sur un procédé d'ajustement de l'état de contrainte d'un film piézoélectrique. Elle porte également sur un procédé de fabrication d'un dispositif à onde acoustiques employant un tel film.

### ARRIERE PLAN TECHNOLOGIQUE DE L'INVENTION

Les matériaux piézoélectriques (c'est-à-dire les matériaux qui présentent une caractéristique piézoélectrique) présentent la particularité de générer des charges électriques sous l'action d'une contrainte mécanique et, réciproquement, de se déformer mécaniquement sous l'effet d'un champ électrique. Ces propriétés sont exploitées dans un grand nombre de dispositifs électroniques tel que les filtres à ondes acoustiques les transducteurs acoustiques, les résonateurs, les capteurs de pression ou d'accélération, les générateurs... Parmi les matériaux piézoélectriques, on peut ainsi citer, et sans rechercher une quelconque exhaustivité, le tantalate de lithium, le niobate de lithium, le quartz, le PZT.

Le document «Sensitivity of surface acoustic wave velocity in lithium niobate to electric field or biasing stress » de D. Gafka et J. Tani, Journal of Applied Physics 73, 7145 (1993) rapporte les résultats d'une étude scientifique cherchant à montrer l'effet d'une contrainte appliquée à du niobate de lithium sur la vélocité des ondes acoustiques de surface. Il propose des cartes de sensitivité de la vélocité de ces ondes vis-à-vis d'une contrainte imposée aux matériaux et propose d'exploiter l'effet de la contrainte pour la conception de filtres, de capteurs, ou de dispositifs de commande à base de niobate de lithium. Toutefois, ce document ne divulgue pas comment ajuster l'état de contrainte de ce matériau.

Le document US2015249033 propose une méthode d'ajustement de l'état de contrainte d'un matériau, notamment un matériau piézoélectrique, en lui imposant une courbure, et en reportant le film courbé sur un support flexible. La mise en oeuvre d'une telle méthode nécessite de déployer des équipements qui ne sont pas standards dans le domaine de l'électronique, ce qui n'est pas avantageux pour l'intégration de ce procédé pour la fabrication d'un dispositif de ce domaine. On connaît également du document EP2159836 et de l'article « Compilant substrates : a comparative study of the relaxation mechanisms of strained films bonded to high and low viscosity oxides », de K.D. Hobart et al, journal of Electronic Material, Vol 29, n° 7, 2000 des méthodes permettant de relaxer un film contraint.

La présente invention vise à fournir un procédé d'ajustement de l'état de contrainte d'un film piézoélectrique particulièrement simple à mettre en oeuvre. Elle vise également à exploiter le film piézoélectrique obtenu à l'issue de ce procédé pour fabriquer un dispositif à ondes acoustiques.

### BREVE DESCRIPTION DE L'INVENTION

En vue de la réalisation de l'un de ces buts, l'objet de l'invention propose un procédé d'ajustement de l'état de contrainte d'un film piézoélectrique présentant à température ambiante un premier état de contrainte, le procédé comprenant :
- Une étape de formation d'un assemblage comportant
   i. un support présentant un coefficient d'expansion thermique ;
   ii. une couche de fluage disposée sur le support, la couche de fluage présentant une température de transition vitreuse supérieure à la température ambiante ;
   iii. le film piézoélectrique disposé sur la couche de fluage, le film piézoélectrique présentant un coefficient d'expansion thermique différent de celui du support ;
- Une étape de traitement thermiquement de l'assemblage, l'étape de traitement thermique comportant :
   i. une première phase portant l'assemblage à une température de traitement supérieure à la température de transition vitreuse de la couche de fluage de manière à relâcher au moins en partie la contrainte du film piézoélectrique engendrée par la différence d'expansion thermique du support et du film piézoélectrique et de manière à placer le film piézoélectrique dans un deuxième état de contrainte ;
   ii. une deuxième phase, postérieure à la première phase, portant l'assemblage à la température ambiante de manière à modifier le deuxième état de contrainte du film piézoélectrique par la différence de contraction thermique du support et du film piézoélectrique et le placer dans un troisième état de contrainte, différent du premier état de contrainte.

Selon d'autres caractéristiques avantageuses et non limitatives de l'invention, prises seules ou selon toute combinaison techniquement réalisable :
- le film piézoélectrique est cristallin ;
- le film piézoélectrique présente une épaisseur comprise entre 10 nm et 20 µm, et de préférence comprise entre 0,3 µm et 1 µm ;
- le film piézoélectrique présente une épaisseur au moins 10 fois inférieure à l'épaisseur du support ;
- la température de transition vitreuse de la couche de fluage est comprise entre 300°C et 1000°C ;
- la couche de fluage est constituée de verre ;
- la couche de fluage présente une épaisseur comprise entre 0,1 et 2 µm ;
- le support présente une épaisseur comprise entre 300 µm et 1 mm ;
- le support présente un coefficient d'expansion thermique supérieure à celui du film piézoélectrique et le troisième état de contrainte est inférieur au premier état de contrainte ;
- le support présente un coefficient d'expansion thermique inférieur à celui du film piézoélectrique et le troisième état de contrainte est supérieur au premier état de contrainte ;
- l'étape de formation de l'assemblage comprend le dépôt de la couche de fluage sur le support et/ou sur un substrat donneur comprenant le film piézoélectrique ;
- l'étape de formation de l'assemblage comprend le collage du substrat donneur avec le support et comprend l'amincissement et/ou la fracture du substrat donneur ;
- le film piézoélectrique est discontinu, et présente une pluralité d'îlots séparés par des tranchées ;
- les îlots présentent une dimension comprise entre 100 et 1000 µm dans les directions dans lesquelles on cherche à ajuster l'état de contrainte ;
- le procédé comprend, après l'étape de traitement thermique, une étape de report du film piézoélectrique sur un support final ;
- la nature du support, de la couche de fluage, et le profil du traitement thermique sont choisi pour que le troisième l'état de contrainte corresponde à un état de contrainte prédéterminé.

L'invention comprend le report d'un film piézoélectrique obtenu à l'issue du procédé d'ajustement qui vient d'être décrit sur un support final.

Selon des caractéristiques avantageuses et non limitatives de ce procédé, prises seules ou selon toute combinaison techniquement réalisable :
- le procédé comprend la formation d'électrodes sur le film piézoélectrique ;
- le support final comprend une couche de surface de piégeage de charges ;
   o le support final comprend un substrat de silicium sur lequel on a formé une couche de silicium polycristallin ;
- le report du film piézoélectrique comprend la formation d'une couche de collage entre le film piézoélectrique et le support final suffisamment rigide pour maintenir l'état de contrainte du film piézoélectrique ;
- la couche de collage comprend de l'oxyde de silicium ou du nitrure de silicium.
- le report de la couche piézoélectrique comprend l'adhésion de la surface libre du film piézoélectrique avec le support final et l'élimination ou le retrait du support.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente schématiquement un procédé d'ajustement de l'état de contrainte d'un film piézoélectrique conforme à l'invention ;
- les figures 2a et 2b représentent l'évolution de la température au cours d'un traitement thermique et l'évolution de l'état de contrainte d'un assemblage au cours de ce traitement thermique, dans un exemple particulier de mise en oeuvre de l'invention.

### DESCRIPTION DETAILLEE DE L'INVENTION

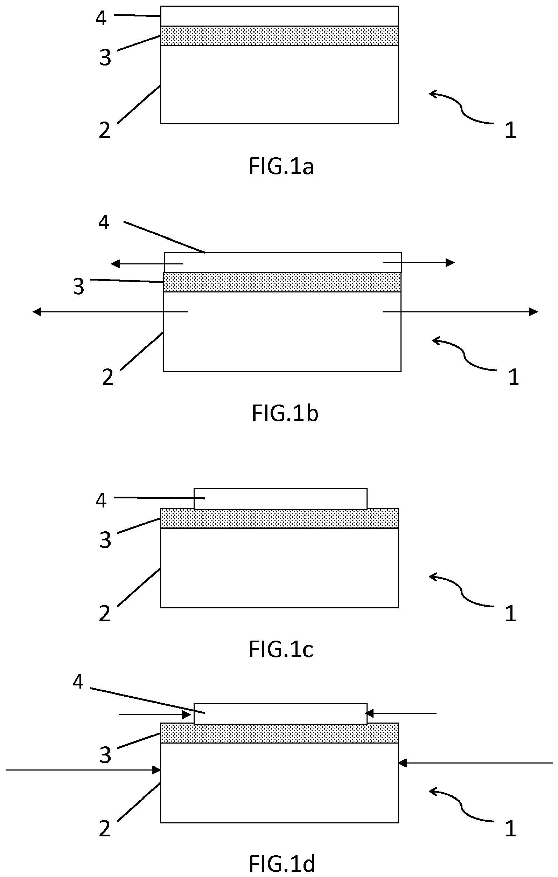

La figure 1 représente schématiquement un procédé d'ajustement de l'état de contrainte d'un film piézoélectrique conforme à l'invention.

Dans une première étape de ce procédé représentée sur la figure 1a, on forme un assemblage 1 comprenant un support 2, une couche de fluage 3 disposée sur le support 2, et un film piézoélectrique 4 disposé sur la couche de fluage 3.

Le film 4 peut être constitué de n'importe quel matériau présentant une propriété piézoélectrique. Il peut notamment s'agir de tantalate de lithium de coupe cristalline Z ou de coupe 42° Y, ou de coupe 36° Y, ou de coupe X ou de n'importe quelle autre coupe cristalline. Il peut s'agir de niobate de lithium de coupe cristalline Z, ou de coupe Y, ou de coupe 128° Y ou de n'importe quelle autre coupe. Il peut également s'agir de PZT, de quartz ou de ZnO.

Le film piézoélectrique 4 est préférentiellement cristallin, sous une forme monocristalline ou polycristalline. À température ambiante, le film piézoélectrique 4 présente un état de contrainte quelconque (et désigné dans la suite de cette description comme le premier état de contrainte). Le premier état de contrainte peut correspondre à un état relaxé, un état contraint en compression, ou en extension. Cet état peut être mesuré, par exemple, à l'aide de techniques connues de diffraction aux rayons X ou par spectroscopie Raman.

Le film piézoélectrique 4 présente avantageusement une épaisseur comprise entre 10 nm et 20 µm, de préférence entre 0,3 µm et 1 µm. Une épaisseur trop faible ou trop importante rend le procédé d'ajustement de contrainte conforme à l'invention plus sensible aux phénomènes de gauchissement du film piézoélectrique 4 ou à sa fissuration. D'une manière générale, il est avantageux que le film piézoélectrique 4 présente une épaisseur bien inférieure à celle du support 2, par exemple d'un ordre de grandeur, de manière à ce que la déformation du support 2 au cours du procédé soit presque entièrement transmise au film 4. Ainsi, le film piézoélectrique 4 présente avantageusement une épaisseur au moins 10 fois inférieure à l'épaisseur du support 2.

La couche de fluage 3 est constituée d'un matériau présentant une température de transition vitreuse Tg supérieure à la température ambiante. On rappelle que cette température Tg correspond à la température en deçà de laquelle un matériau est considéré comme rigide, et au-delà de laquelle le matériau est considéré comme souple et apte à se déformer. La couche de fluage 3 peut être constituée de verre, par exemple de verre de borophosphosilicate (BPSG) ou de phosphosilicate (PSG) ou de borosilicate (BSG) ou encore de germanophosphosilicate.

La couche de fluage 3 est choisie, ou les éléments constituant cette couche sont choisis, pour que la température de transition vitreuse Tg soit suffisamment élevée pour que le procédé de l'invention ait des effets remarquables, sans toutefois excéder une température limite qu'il serait difficile d'atteindre industriellement. Typiquement, la température de transition vitreuse Tg de la couche de fluage 3 est comprise entre 300°C et 1000°C. La couche de fluage 3 est typiquement formée par dépôt sur le support 2 et présente une épaisseur qui peut être comprise entre 0,1 et 2 µm. Le support 2 est quant à lui constitué d'un bloc de matériaux quelconque. Il peut prendre la forme d'une plaquette de matériaux, c'est-à-dire d'un disque présentant une épaisseur de 1 mm ou moins et dont le diamètre peut être normalisé, par exemple de 100 mm, 200 mm, ou 300 mm.

D'une manière générale, comme on l'a vu précédemment, le support 2 présente une épaisseur bien supérieure à celle du film piézoélectrique 4, par exemple d'un ordre de grandeur. Il peut s'agir d'un bloc de matériau présentant une épaisseur comprise entre 300 µm à 1 mm, et être constitué (ou comprendre) de silicium, de saphir, de quartz ou d'un matériau piézoélectrique tel que du niobate de lithium. Il peut également s'agir d'arséniure de gallium, de molybdène, de nitrure d'aluminium, de carbure de silicium... Le matériau constituant le support peut prendre une forme cristalline ou polycristalline.

Selon l'invention, le coefficient d'expansion thermique du support 2 est différent du coefficient d'expansion thermique du film piézoélectrique 4.

Selon l'invention, cette différence excède 5% ou avantageusement 10%, de manière à provoquer des effets particulièrement notables. Lorsque le matériau formant le support 2 ou le film piézoélectrique 4 ne sont pas isotropes, il existe au moins une direction comprise dans le plan défini par le film 4 selon laquelle les coefficients d'expansion thermique du support 2 et du film piézoélectrique 4 sont différents.

On note que l'état de contrainte est exprimé dans le cadre de la présente demande comme un nombre réel dont la valeur absolue désigne l'intensité de la contrainte (par exemple en Pascal) et dont le signe désigne la nature de cette contrainte, soit en compression (signe négatif) ou en tension (signe positif). Un état parfaitement relaxé présente un état de contrainte nul. En conséquence, les expressions « augmenter » ou « réduire » l'état de contrainte portent sur le nombre réel reflétant cet état de contrainte, et non sur son intensité.

Comme cela sera détaillé dans la suite de cet exposé, on pourra choisir un support 2 présentant un coefficient d'expansion thermique supérieur à celui du film piézoélectrique 4 pour réduire le premier état de contrainte du film piézoélectrique 4 et le placer dans un troisième état de contrainte. En d'autres termes, le troisième état de contrainte dans ce cas est inférieur au premier état de contrainte.

Alternativement, on pourra choisir un support 2 présentant un coefficient d'expansion thermique inférieur à celui du film piézoélectrique 4 pour augmenter le premier état de contrainte du film piézoélectrique 4, et le placer dans un troisième état de contrainte. En d'autres termes, le troisième état de contrainte dans ce cas est supérieur au premier état de contrainte.

Toutes méthodes d'assemblage peuvent convenir pour former l'assemblage 1. Il peut s'agir par exemple d'un assemblage par collage du support 2 à un substrat donneur comprenant le film piézoélectrique 4, et par et amincissement et/ou fracture du substrat donneur. On pourra notamment mettre en oeuvre la technologie Smart Cut^{™}, bien connue en soi et dont l'application à un matériau piézoélectrique est enseignée dans le document US6190998. On pourra munir le support 2 et/ou le substrat donneur de la couche de fluage 3 avant de les assembler l'un à l'autre. Après amincissement du substrat donneur, on aboutit à l'assemblage 1 tel qui vient d'être décrit. La méthode d'assemblage peut également être une opérée par dépôt d'un matériau piézoélectrique sur la couche de fluage 3, elle-même disposée sur le support 2. Le matériau piézoélectrique déposé forme alors le film 4.

On peut prévoir une ou plusieurs couches additionnelles comprises entre la couche de fluage 3 et le film piézoélectrique 4, entre la couche de fluage 3 et le support 2, ou sur le film piézoélectrique 4. Une au moins de ces couches additionnelles, notamment lorsqu'elle est positionnée directement sous le film 4, peut constituer une couche barrière afin d'éviter la diffusion d'impuretés pouvant provenir de la couche de fluage 3 ou du support 2 vers le film piézoélectrique 4. Il peut également s'agir d'une couche tampon visant à favoriser le dépôt du film piézoélectrique 4 selon une orientation cristalline particulière, lorsque celui-ci est effectivement formé par dépôt. Il peut aussi s'agir de couches positionnées entre le support 2 et le film 4 permettant ou facilitant le démontage du support 2 du film piézoélectrique 4, à l'issue du procédé. Il peut s'agir d'une couche raidisseur disposée sur la couche piézoélectrique 4, comme cela sera détaillé dans la suite de cet exposé.

En tout état de cause et quelle que soit la méthode d'assemblage employée, on dispose à l'issue de l'étape qui vient d'être décrite, d'un assemblage 1 comprenant au moins le support 2, la couche de fluage 3 disposée sur le support 2, et le film piézoélectrique 4 disposé sur la couche de fluage.

Le procédé conforme à l'invention comprend également une deuxième étape, postérieure à celle qui vient d'être décrite, de traitement thermique de l'assemblage 1. Cette étape de traitement thermique est composée de deux phases.

Au cours d'une première phase, on porte l'assemblage 1 qui peut être initialement à température ambiante (c'est à dire entre 10°C et 50°C) à une température de traitement Tr supérieure à la température de transition vitreuse Tg de la couche de fluage 3. Au cours de cette première phase, et tant que la température à laquelle est exposée l'assemblage 1 est inférieure à la température de transition vitreuse Tg, le support 2 et le film piézoélectrique 4 se dilatent. Cet état est schématiquement représenté sur la figure 1b. Présentant des coefficients d'expansion thermique différents, la dilatation du film 4 et du support 2 ne sont pas identiques. Le support 2 étant bien plus épais que le film 4, celui-ci a tendance à imposer sa déformation au film 4, qui est donc placé dans un état de contrainte différent du premier état de contrainte. La contrainte du film 4 en ce début de première phase du traitement thermique est en tension lorsque le coefficient d'expansion thermique du support 2 est supérieur au coefficient d'expansion thermique du film piézoélectrique 4 et en compression dans le cas contraire.

Dès que la température à laquelle est exposé l'assemblage 1 excède la température de transition vitreuse Tg de la couche de fluage 3, celle-ci devient susceptible de se déformer. Les contraintes du film piézoélectrique 4 engendrées par la différence de coefficient d'expansion thermique entre le support 2 et le film 4 sont alors au moins en partie relaxées. Cette relaxation se réalise par l'expansion ou la rétractation latérale du film piézoélectrique 4 rendue permise par la faible viscosité de la couche de fluage à la température de traitement Tr. Cet état est représenté schématiquement sur la figure 1c. Le film piézoélectrique 4 est donc placé à l'issue de cette première phase dans un deuxième état de contrainte qui peut correspondre ou être proche d'un état relaxé.

Pour favoriser cette relaxation, la température de traitement Tr à laquelle est exposé l'assemblage 1 peut excéder la température de transition vitreuse Tg de la couche de fluage 3 de 10°C ou plus. Et la période de temps pendant laquelle l'assemblage 1 est exposé à une température supérieure à la température de fluage Tg peut être supérieure à 1 heure. La première phase du traitement thermique peut comprendre ou consister en une rampe de température, progressant linéairement ou non, et passant de la température initiale à la température de traitement Tr. La première phase peut ainsi comprendre un plateau à cette température de traitement Tr ou un cyclage autour de cette température de traitement Tr ou tout autre profil de température dans la mesure où celle-ci excède la température de transition vitreuse Tg de la couche de fluage 3, afin de favoriser l'expansion ou la rétractation latérale du film piézoélectrique 4.

Dans une deuxième phase du traitement thermique, postérieure à la première phase, on porte l'assemblage 1 de la température de traitement Tr à la température ambiante. Dès que la température de l'assemblage passe sous la température de transition vitreuse Tg de la couche de fluage 3, celle-ci se solidifie à nouveau. Similairement à ce qui s'est passé au cours de la première phase, la contraction du support 2, différente de la contraction du film piézoélectrique 4, conduit à placer le film piézoélectrique 4 dans un troisième état de contrainte une fois l'assemblage 1 revenu à la température ambiante, comme cela est schématiquement représenté sur la figure 1d. La seconde phase peut comprendre ou consister en une rampe de température, linéaire ou non, ramenant la température de l'assemblage 1 de la température de traitement Tr à la température ambiante.

En prenant comme hypothèse que le premier état de contrainte du film piézoélectrique en début de procédé est essentiellement un état relaxé, la contrainte du film 4 à l'issue du traitement thermique est en compression lorsque le coefficient d'expansion thermique du support 2 est supérieur au coefficient d'expansion thermique du film piézoélectrique 4, et en tension dans le cas contraire.

En tout état de cause, et quelle que soit les valeurs relatives du coefficient d'expansion thermique du support 2 et du film piézoélectrique 4, on aboutit à l'issue de la deuxième phase de l'étape de traitement thermique, à un film piézoélectrique 4 présentant un troisième état de contrainte, en tension ou en compression, différent du premier état de contrainte. Le relâchement de la contrainte qui s'opère en fin de premières phases et/ou en début de deuxième phase, au-dessus de la température de transition vitreuse Tg, conduit à ajuster l'état de contrainte du film. En choisissant de manière appropriée la nature du support 2, de la couche de fluage 3, et le profil du traitement thermique, on peut ajuster l'état de contrainte du film (le troisième état de contrainte) pour qu'il corresponde à un état de contrainte prédéterminé.

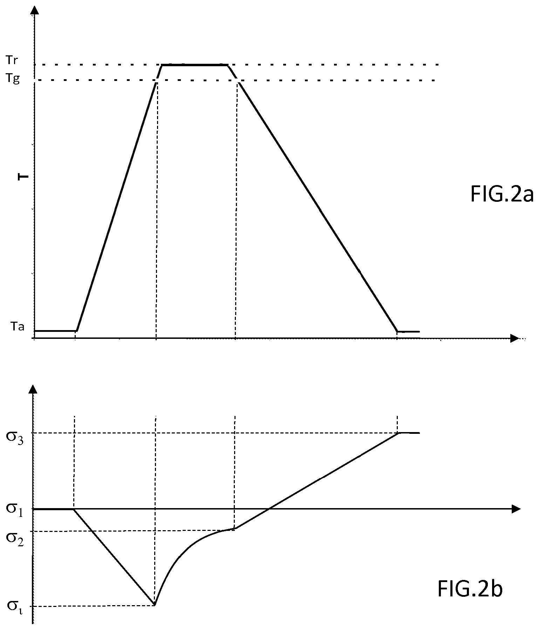

On a ainsi représenté sur la figure 2a l'évolution de la température au cours d'un traitement thermique conforme à l'invention et, sur la figure 2b, l'évolution de l'état de contrainte du film piézoélectrique 4 de l'assemblage 1 au cours de ce traitement thermique. Dans l'exemple représenté, le premier état de contrainte σ1 du film 4 est essentiellement relaxé. Le coefficient d'expansion thermique du support 2 est inférieur au coefficient d'expansion thermique du film piézoélectrique 4. En conséquence, au cours de l'élévation en température de l'assemblage entre la température ambiante Ta et la température de transition vitreuse Tg, le film piézoélectrique 4 est mis dans un état de contrainte intermédiaire σi en compression. Lorsque la température excède la température de transition vitreuse Tg, notamment au cours du plateau à la température de traitement Tr, on observe la relaxation partielle de la contrainte du film 4, liée à la déformation de la couche de fluage et à l'expansion latérale du film 4. A la fin de la première phase du traitement thermique, le film piézoélectrique présente un deuxième état de contrainte σ2, proche d'un état relaxé. La seconde phase du traitement thermique, notamment lorsque la température redescend sous la température de transition vitreuse Tg, conduit à ajuster l'état de contrainte du film piézoélectrique 4 pour le placer dans le troisième état de contrainte σ3, différent du premier.

Un procédé conforme à l'invention peut comprendre des étapes additionnelles.

On peut ainsi appliquer à l'assemblage 1 au moins un traitement thermique complémentaire de manière à favoriser la relaxation du deuxième état de contrainte et ajuster plus finement si nécessaire le troisième état de contrainte. Bien entendu ce traitement thermique complémentaire, pour avoir un effet, doit porter l'assemblage 1 à une température de traitement supérieure à la température de transition vitreuse Tg de la couche de fluage 3.

Afin de limiter l'éventuel gauchissement ou fissuration du film piézoélectrique 4 lors de l'expansion ou la contraction latérale du film 4 à la température de traitement, on peut prévoir, avant l'étape de traitement thermique, de rendre le film piézoélectrique 4 discontinu. Cette étape optionnelle est particulièrement avantageuse lorsque le film piézoélectrique 4 présente une dimension importante, s'étendant par exemple sur plusieurs centimètres ou millimètres, et que l'on cherche à préserver ses qualités morphologiques. On peut ainsi former des tranchées, par exemple par application d'un masque photolithographique à la surface du film 4 et par gravure, s'étendant dans toute l'épaisseur du film 4 et éventuellement dans la couche de fluage 3. Ces tranchées définissent des îlots dans le film piézoélectrique 4. Les îlots peuvent présenter une dimension comprise entre 100 et 1000 µm dans la direction (ou dans les directions) dans laquelle on cherche à ajuster l'état de contrainte. Les îlots peuvent présenter une forme quelconque, carrée, ronde, hexagonale notamment lorsque la contrainte appliquée sur le film 4 par le support lors du traitement thermique est isotropique. Lorsque la différence entre les coefficients d'expansion thermique du support 2 et du film 4 n'existe que selon une direction privilégiée du plan principal (comme cela peut être le cas si le support 2 ou le film piézoélectrique 4 est anisotrope), et donc que la contrainte est appliquée sur les îlots du film piézoélectrique 4 majoritairement selon cette direction privilégiée du plan principal, ceux-ci peuvent se présenter sous la forme de bandes perpendiculaires à la direction principale, de largeur comprise entre 100 µm et 1 mm. Les îlots peuvent également se présenter sous la forme de rectangles, dont les longueurs et largeurs sont ajustées à l'intensité des contraintes qui s'appliquent selon ces deux directions.

Quelle que soit la forme des îlots, la largeur des tranchées séparant deux îlots peut être comprise entre 1 et 50 µm.

Le procédé conforme à l'invention peut également comprendre, avant l'étape de traitement thermique, l'application d'une couche raidisseur sur le film piézoélectrique 4. Cette couche raidisseur peut contribuer à favoriser l'expansion ou la contraction latérale du film piézoélectrique 4 (ou des îlots formant ce film) et limiter son gauchissement, comme cela est détaillé dans le document « Buckling suppression of SiGe islands on compilant substrates », Yin et al (2003), Journal of Applied Physics, 94(10), 6875-6882.

Le procédé d'ajustement de contrainte trouve son application pour la fabrication de dispositifs tirant profit de l'état de contrainte ajustée de la couche piézoélectrique 4. Selon l'invention, il s'agit d'un dispositif à onde acoustique comprenant un support final et une couche piézoélectrique 4, telle qu'obtenue à l'issue du procédé d'ajustement de l'état de contrainte qui vient d'être présenté. Le dispositif peut comprendre des électrodes disposées sur la couche piézoélectrique 4, pour coupler les ondes acoustiques qui s'y propagent avec des conducteurs électriques.

On prévoit donc, à l'issue de l'étape de traitement thermique du procédé d'ajustement de l'état de contrainte du film piézoélectrique 4, de reporter ce film 4 dans son troisième état de contrainte sur un support final. C'est notamment le cas lorsque la couche de fluage 3 présente une nature incompatible avec l'application finale envisagée pour le film 4. Le report du film 4 sur un support final permet également de dissocier les propriétés requises du support pour ajuster au mieux l'état de contrainte du film, des propriétés requises du support dans son application finale. Ainsi, lorsque le film piézoélectrique 4 est destiné à constituer des filtres à ondes acoustiques pour des applications radiofréquences, on peut envisager de fournir un support final comprenant une couche de surface de piégeage de charges, comme cela est par exemple décrit dans les documents FR2860341, FR2933233, FR2953640, US2015115480, US7268060 ou US6544656. Typiquement ce support final peut comprendre un substrat de silicium sur lequel on a formé une couche de silicium polycristallin.

On veillera que l'étape de report du film 4 sur le support final préserve au moins en partie l'état de contrainte qui lui a été imparti au cours du procédé conforme à l'invention. Cela peut être obtenu en formant l'assemblage entre le film piézoélectrique et le support final à l'aide d'une couche de collage suffisamment rigide pour maintenir cet état de contrainte. Dans le cas où le report est réalisé par collage direct du film 4 sur le support final, cette couche de collage peut être constitué, ou comprendre, d'un oxyde de silicium ou d'un nitrure de silicium.

Ce report peut être opéré par tous moyens connus en soi. À titre d'exemple, il peut s'agir de faire adhérer la surface libre du film piézoélectrique 4 sur le support final puis d'éliminer ou de procéder au retrait du support 2. On peut à ce propos avoir prévu entre la couche de fluage 3 et le support 2 ou entre la couche de fluage 3 et le film piézoélectrique une couche de démontage, apte à se décomposer par exemple par gravure chimique humide ou lorsqu'elle est irradiée par une illumination laser.

### Exemple 1

On forme par dépôt en phase vapeur sur un support 2 constitué d'un substrat de silicium (présentant une épaisseur de 675 µm & de coefficient d'expansion thermique de 2,6 à 4,4 E-6 K-1 entre 10 et 1000°C), une couche de dioxyde de silicium dopée au bore et au phosphore pour former une couche de fluage 3 de 1 µm d'épaisseur. La couche de fluage comprend, outre le dioxyde de silicium, 6 % molaire de B2O3 et 2 % molaire de P2O3, si bien que la température de transition vitreuse Tg de cette couche est de 700 °C environ.

Pour former l'assemblage 1 de l'invention, on assemble le support 2 en silicium muni de la couche de fluage 3 avec un substrat donneur de niobate de lithium de coupe cristalline Z (de coefficient d'expansion thermique selon l'axe Y et selon l'axe X de 15,4 E-6) par collage direct. Ce substrat donneur est ensuite aminci par polissage mécanico-chimique pour former un film piézoélectrique 4 de 4 µm d'épaisseur. Celui-ci est ensuite aminci par gravure sèche pour amener son épaisseur à 1,5 µm. Optionellement, on peut masquer le film par photolithographie, et par gravure chimique définir des îlots carrés de 300 µm de côté dans le film piézoélectrique 4. Le film 4, qu'il soit ainsi constitué d'îlots ou non, présente un premier état de contrainte essentiellement relaxé à température ambiante.

On applique ensuite un traitement thermique conforme à l'invention, comprenant une première phase constituée d'une rampe linéaire portant l'assemblage 1 à une température de traitement Tr de 710° pendant une heure. En conséquence de la différence d'expansion thermique du film 4 et du support 2, on induit une contrainte de l'ordre de 2,5 GPa dans le film piézoélectrique 4 avant que celui-ci ne se relaxe au cours du plateau à la température de traitement Tr, qui excède de 10°C la température de transition vitreuse Tg de la couche de fluage.

La deuxième phase comprend une rampe linéaire ramenant la température de l'assemblage 1 à la température ambiante. La différence de coefficient d'expansion thermique entre le film piézoélectrique 4 et le support 2 de silicium conduit à placer le film dans un état de contrainte en tension. Cette contrainte, à température ambiante, dans les îlots formant le film peut atteindre 2 GPa.

Dans cet exemple, les îlots piézoélectriques formant le film 4 contraint en tension sont ensuite transférés sur un support final, par exemple en silicium, afin de finaliser la fabrication de dispositifs acoustiques, tels que des filtres.

### Exemple 2

Dans ce deuxième exemple, on forme sur un support 2 en saphir de coupe Z (présentant une épaisseur de 625 µm & de coefficient d'expansion thermique selon la direction X entre 5 et 7,5 E-6 K-1) un empilement comprenant une première couche de dioxyde de silicium en contact avec le support 2, une seconde couche de nitrure de silicium et une couche de fluage 3 en BPSG, sur la deuxième couche. La première et la deuxième couche présentent une épaisseur de l'ordre de 1,5 µm. La couche de fluage 3 présente une épaisseur de 1,2 µm. La proportion de bore et de phosphore dans la couche de fluage 3 conduisent à définir sa température de transition vitreuse Tg à 600° C.

Sur la couche de fluage 3 on rapporte un film de tantalate de lithium de coupe 42° Y (de coefficient d'expansion thermique selon la direction X de 16 E-6 et de coefficient d'expansion thermique selon la direction perpendiculaire à X et contenue dans le plan du film d'environ 10,6 E-6 ) de 0,5 µm d'épaisseur par application de la technologie Smart Cut^{™}. À cet effet, on a implanté d'espèces légères (hydrogène, hélium par exemple) un substrat de tantalate de lithium pour y définir le film piézoélectrique 4. On a assemblé ensuite, par collage direct, ce substrat donneur avec le support 2 muni de la couche de fluage 3 et appliqué des efforts mécaniques et/ou thermiques au niveau de la zone implantée pour conduire à sa fracture et transférer le film sur le support 2. À température ambiante, le film présente un premier état de contrainte essentiellement relaxée.

À l'aide d'une technologie similaire à celle présentée dans le premier exemple, on forme dans le film continu piézoélectrique 4 des îlots rectangulaires dont la largeur est d'environ 100 µm selon la direction X du film piézoélectrique 5 et la longueur de 500 µm dans une direction perpendiculaire à cette direction X.

On applique un traitement thermique visant à porter l'assemblage 1 à 650°C pendant trois heures, excédant donc la température de transition vitreuse Tg de la couche de fluage 3.

Comme dans l'exemple précédent, la différence de coefficient d'expansion thermique entre le film piézoélectrique 4 et le support 2 de saphir conduit à placer le film dans un état de contrainte en tension à l'issue du traitement thermique. Cette contrainte, à température ambiante, dans les îlots formant le film peut atteindre 2 GPa.

Puis, les îlots contraints formant le film piézoélectrique 4 sont reportés sur un support final en silicium. À cet effet, on dépose et on planarise un film de dioxyde de silicium sur et entre les îlots. Puis, on assemble la surface ainsi préparée à un substrat receveur de silicium, et on irradie la face arrière du support en saphir par un laser dont la longueur d'onde est choisie pour pénétrer dans l'épaisseur du support en saphir 2 et de la première couche, et être absorbée par la deuxième couche de nitrure de silicium pour la décomposer. Une fois cette deuxième couche décomposée, le support 2 en saphir peut être démonté de l'assemblage 1.

### Exemple 3

Dans ce troisième exemple, l'assemblage est formé en déposant par dépôt chimique en phase vapeur sur un support 2 de silicium (présentant une épaisseur de 675 µm et un coefficient d'expansion thermique de 2,6 E-6 à 4,4 E-6 K-1 entre 10 et 1000°C) une couche de fluage 3 en BPSG présentant une température de transition vitreuse de 800°C. Sur la couche de fluage, on dépose une couche de titane, puis sur cette couche de titane, on forme également par dépôt un film piézoélectrique 4 de titanate de plomb et de zirconium (PZT). Le premier état de contrainte du film 4 est dépendant des conditions de dépôt et de la nature du support 2. Il peut être essentiellement relaxé, ou présenter un état de contrainte, en tension ou en compression, différent. On forme des îlots carrés de 300 µm de côté dans le film 4, et on applique le traitement thermique de l'invention, en portant l'assemblage 1 à une température de traitement de 850°C pendant 1 heure. Comme dans les exemples précédents, la différence de coefficient d'expansion thermique entre le film piézoélectrique 4 et le support 2 conduit à placer le film à l'issue du traitement thermique dans un état de contrainte différent du premier état de contrainte.

Bien entendu l'invention n'est pas limitée au mode de mise en oeuvre décrit et on peut y apporter des variantes de réalisation sans sortir du cadre de l'invention tel que défini par les revendications.

## Revendications

1. Procédé de fabrication d'un dispositif à onde acoustique comprenant le report d'un film piézoélectrique (4) obtenu à l'issue d'un procédé d'ajustement de contrainte sur un support final, le procédé d'ajustement de l'état de contrainte du film piézoélectrique (4), présentant à température ambiante un premier état de contrainte, comprenant :
- Une étape de formation d'un assemblage (1) comportant
i. un support (2) présentant un coefficient d'expansion thermique ;
ii. une couche de fluage (3) disposée sur le support (2), la couche de fluage (3) présentant une température de transition vitreuse (Tg) supérieure à la température ambiante ;
iii. le film piézoélectrique (4) disposé sur la couche de fluage (3), le film piézoélectrique présentant un coefficient d'expansion thermique différent d'au moins 5% de celui du support ;
- Une étape de traitement thermique de l'assemblage (1), l'étape de traitement thermique comprenant :
i. une première phase portant l'assemblage (1) à une température de traitement supérieure à la température de transition vitreuse (Tg) de la couche de fluage (3) de manière à relâcher au moins en partie la contrainte du film piézoélectrique engendrée par la différence d'expansion thermique du support (2) et du film piézoélectrique (4) et de manière à placer le film piézoélectrique (4) dans un deuxième état de contrainte ;
ii. une deuxième phase, postérieure à la première phase, portant l'assemblage (1) à la température ambiante de manière à modifier le deuxième état de contrainte du film piézoélectrique (4) par la différence de contraction thermique du support (2) et du film piézoélectrique (4) et le placer dans un troisième état de contrainte, différent du premier état de contrainte.

2. Procédé de fabrication selon la revendication précédente dans lequel le film piézoélectrique (4) est cristallin.

3. Procédé de fabrication selon l'une des revendications précédentes dans lequel le film piézoélectrique (4) présente une épaisseur au moins 10 fois inférieure à l'épaisseur du support (2).

4. Procédé de fabrication selon l'une des revendications précédentes dans lequel la température de transition vitreuse (Tg) de la couche de fluage (3) est comprise entre 300°C et 1000°C.

5. Procédé de fabrication selon l'une des revendications précédentes dans lequel le support (2) présente un coefficient d'expansion thermique supérieure à celui du film piézoélectrique (4) et le troisième état de contrainte est inférieur au premier état de contrainte.

6. Procédé de fabrication selon l'une des revendications 1 à 4 dans lequel le support (2) présente un coefficient d'expansion thermique inférieur à celui du film piézoélectrique (4) et le troisième état de contrainte est supérieur au premier état de contrainte.

7. Procédé de fabrication selon l'une des revendications précédentes dans lequel l'étape de formation de l'assemblage
(1) comprend le dépôt de la couche de fluage (1) sur le support
(2) et/ou sur un substrat donneur comprenant le film piézoélectrique (4).

8. Procédé de fabrication selon la revendication précédente dans lequel l'étape de formation de l'assemblage (1) comprend le collage du substrat donneur avec le support (3) et comprend l'amincissement et/ou la fracture du substrat donneur.

9. Procédé de fabrication selon l'une des revendications précédentes dans lequel le film piézoélectrique (4) est discontinu, et présente une pluralité d'îlots séparés par des tranchées.

10. Procédé de fabrication selon l'une des revendications précédentes, dans lequel la nature du support (2), de la couche de fluage (3), et le profil du traitement thermique sont choisi pour que le troisième l'état de contrainte corresponde à un état de contrainte prédéterminé.

11. Procédé de fabrication selon l'une des revendications précédentes comprenant la formation d'électrodes sur le film piézoélectrique (4).

12. Procédé de fabrication selon la revendication précédente, dans lequel support final comprend une couche de surface de piégeage de charges.

13. Procédé de fabrication selon la revendication précédente dans lequel le support final comprend un substrat de silicium sur lequel on a formé une couche de silicium polycristallin.

14. Procédé de fabrication selon l'une des revendications précédentes dans lequel le report du film piézoélectrique comprend la formation d'une couche de collage entre le film piézoélectrique et le support final suffisamment rigide pour maintenir l'état de contrainte du film piézoélectrique.

15. Procédé de fabrication selon la revendication précédente dans lequel la couche de collage comprend de l'oxyde de silicium ou du nitrure de silicium.

16. Procédé selon l'une des revendications précédentes dans lequel le report de la couche piézoélectrique (4) comprend l'adhésion de la surface libre du film piézoélectrique avec le support final et l'élimination ou le retrait du support (2) .

## Patentansprüche

1. Verfahren zum Herstellen einer Schallwellenvorrichtung, umfassend das Übertragen eines piezoelektrischen Films (4) der aus einen Spannungsanpassungsverfahren erhalten wird, auf einen Endträger, das Verfahren zum Anpassen des Spannungszustands des piezoelektrischen Films (4), der bei Umgebungstemperatur einen ersten Spannungszustand aufweist, umfassend:
- einen Schritt eines Ausbildens einer Anordnung (1), die vorweist:
i. einen Träger (2), der einen Wärmeausdehnungskoeffizienten aufweist;
ii. eine Kriechschicht (3), die auf dem Träger (2) eingerichtet ist, wobei die Kriechschicht (3) eine Glasübergangstemperatur (Tg) aufweist, die größer als die Umgebungstemperatur ist;
iii. einen piezoelektrischen Film (4), der auf der Kriechschicht (3) eingerichtet ist, wobei der piezoelektrische Film einen Wärmeausdehnungskoeffizienten von mindestens 5 % dem des Trägers aufweist;
- einen Schritt eines Wärmebehandelns der Anordnung (1), der Wärmebehandlungsschritt umfassend:
i. eine erste Phase, die die Anordnung (1) auf eine Behandlungstemperatur bringt, die größer als die Glasübergangstemperatur (Tg) der Kriechschicht (3) ist, sodass die Spannung des piezoelektrischen Films mindestens teilweise gelöst wird, die durch den Wärmeausdehnungsunterschied des Trägers (2) und des piezoelektrischen Films (4) erzeugt wird, und sodass der piezoelektrische Film (4) in einen zweiten Spannungszustand versetzt wird;
ii. eine zweite Phase nach der ersten Phase, die die Anordnung (1) auf die Umgebungstemperatur bringt, sodass der zweite Spannungszustand des piezoelektrischen Films (4) durch den Wärmeschrumpfungsunterschied des Trägers (2) und des piezoelektrischen Films (4) geändert wird und er in einen dritten Spannungszustand versetzt wird, der sich von dem ersten Spannungszustand unterscheidet.

2. Herstellungsverfahren nach dem vorstehenden Anspruch, wobei der piezoelektrische Film (4) kristallin ist.

3. Herstellungsverfahren nach einem der vorstehenden Ansprüche, wobei der piezoelektrische Film (4) eine Dicke aufweist, die mindestens 10-mal geringer als die Dicke des Trägers (2) ist.

4. Herstellungsverfahren nach einem der vorstehenden Ansprüche, wobei die Glasübergangstemperatur (Tg) der Kriechschicht (3) zwischen 300 °C und 1000 °C liegt.

5. Herstellungsverfahren nach einem der vorstehenden Ansprüche, wobei der Träger (2) einen Wärmeausdehnungskoeffizienten aufweist, der größer als der des piezoelektrischen Films (4) ist, und der dritte Spannungszustand geringer als der erste Spannungszustand ist.

6. Herstellungsverfahren nach einem der Ansprüche 1 bis 4, wobei der Träger (2) einen Wärmeausdehnungskoeffizienten aufweist, der geringer als der des piezoelektrischen Films (4) ist, und der dritte Spannungszustand größer als der erste Spannungszustand ist.

7. Herstellungsverfahren nach einem der vorstehenden Ansprüche, wobei der Ausbildungsschritt der Anordnung (1) das Abscheiden der Kriechschicht (1) auf den Träger (2) und/oder auf ein Donorsubstrat umfasst, umfassend den piezoelektrischen Film (4).

8. Herstellungsverfahren nach dem vorstehenden Anspruch, wobei der Ausbildungsschritt der Anordnung (1) das Verkleben des Donorsubstrats mit dem Träger (3) umfasst und die Verkleinerung und/oder das Zerbrechen des Donorsubstrats umfasst.

9. Herstellungsverfahren nach einem der vorstehenden Ansprüche, wobei der piezoelektrische Film (4) unterbrochen ist und eine Vielzahl von Inseln aufweist, die durch Gräben getrennt sind.

10. Herstellungsverfahren nach einem der vorstehenden Ansprüche, wobei die Beschaffenheit des Trägers (2), der Kriechschicht (3) und das Profil der Wärmebehandlung ausgewählt sind, damit der dritte Spannungszustand einem vorbestimmten Spannungszustand entspricht.

11. Herstellungsverfahren nach einem der vorstehenden Ansprüche, umfassend die Ausbildung von Elektroden auf dem piezoelektrischen Film (4).

12. Herstellungsverfahren nach dem vorstehenden Anspruch, wobei der Endträger eine Schicht einer Ladungseinfangoberfläche umfasst.

13. Herstellungsverfahren nach dem vorstehenden Anspruch, wobei der Endträger ein Siliziumsubstrat umfasst, auf dem eine Schicht aus polykristallinem Silizium ausgebildet wurde.

14. Herstellungsverfahren nach einem der vorstehenden Ansprüche, wobei das Übertragen des piezoelektrischen Films die Ausbildung einer Klebeschicht zwischen dem piezoelektrischen Film und dem Endträger umfasst, die ausreichend steif ist, um den Spannungszustand des piezoelektrischen Films beizubehalten.

15. Herstellungsverfahren nach dem vorstehenden Anspruch, wobei die Klebeschicht Siliziumoxid oder Siliziumnitrid umfasst.

16. Verfahren nach einem der vorstehenden Ansprüche, wobei das Übertragen der piezoelektrischen Schicht (4) das Haften der freien Oberfläche des piezoelektrischen Films an dem Endträger und das Entfernen oder das Zurückziehen des Trägers (2) umfasst.

## Claims

1. Method for producing an acoustic wave device comprising transferring a piezoelectric film (4) obtained after a process for adjusting the stress on a final carrier, the process for adjusting the stress state of the piezoelectric film (4), which has a first stress state at room temperature, comprising:
- a step of forming an assembly (1) comprising
i. a carrier (2) having a coefficient of thermal expansion;
ii. a creep layer (3) arranged on the carrier (2), the creep layer (3) having a glass transition temperature (Tg) higher than room temperature;
iii. the piezoelectric film (4) arranged on the creep layer (3), the piezoelectric film having a coefficient of thermal expansion which is different from that of the carrier by at least 5%;
- a heat treatment step of the assembly (1), the heat treatment step comprising:
i. a first stage of bringing the assembly (1) to a process temperature higher than the glass transition temperature (Tg) of the creep layer (3) so as to at least partially release the stress of the piezoelectric film produced by the difference in thermal expansion of the carrier (2) and the piezoelectric film (4) and so as to place the piezoelectric film (4) in a second stress state;
ii. a second stage, following the first phase, of bringing the assembly (1) to room temperature so as to modify the second stress state of the piezoelectric film (4) by the difference in thermal contraction between the carrier (2) and the piezoelectric film (4) and place it in a third stress state, which is different from the first stress state.

2. Production method according to the preceding claim, wherein the piezoelectric film (4) is crystalline.

3. Production method according to either of the preceding claims, wherein the piezoelectric film (4) has a thickness at least 10 times less than the thickness of the carrier (2).

4. Production method according to any of the preceding claims, wherein the glass transition temperature (Tg) of the creep layer (3) is between 300°C and 1000°C.

5. Production method according to any of the preceding claims, wherein the carrier (2) has a higher coefficient of thermal expansion than that of the piezoelectric film (4) and the third stress state is lower than the first stress state.

6. Production method according to any of claims 1 to 4, wherein the carrier (2) has a lower coefficient of thermal expansion than that of the piezoelectric film (4) and the third stress state is greater than the first stress state.

7. Production method according to any of the preceding claims, wherein the step of forming the assembly (1) comprises depositing the creep layer (1) on the carrier (2) and/or on a donor substrate comprising the piezoelectric film (4).

8. Production method according to the preceding claim, wherein the step of forming the assembly (1) comprises bonding the donor substrate to the carrier (3) and comprises thinning and/or fracturing the donor substrate.

9. Production method according to any of the preceding claims, wherein the piezoelectric film (4) is discontinuous, and has a plurality of islands separated by trenches.

10. Production method according to any of the preceding claims, wherein the nature of the carrier (2), the creep layer (3), and the heat treatment profile are chosen so that the third stress state corresponds to a predetermined stress state.

11. Production method according to any of the preceding claims, comprising the formation of electrodes on the piezoelectric film (4).

12. Production method according to the preceding claim, wherein the final carrier comprises a charge trapping surface layer.

13. Production method according to the preceding claim, wherein the final carrier comprises a silicon substrate on which a layer of polycrystalline silicon has formed.

14. Production method according to any of the preceding claims, wherein the transfer of the piezoelectric film comprises the formation of a bonding layer between the piezoelectric film and the final carrier which is sufficiently rigid to maintain the stress state of the piezoelectric film.

15. Production method according to the preceding claim, wherein the bonding layer comprises silicon oxide or silicon nitride.

16. Method according to any of the preceding claims, wherein the transfer of the piezoelectric layer (4) comprises adhering the free surface of the piezoelectric film to the final carrier and removing or withdrawing the carrier (2).
